# EUROPEAN PATENT APPLICATION

(11) **EP 1 337 046 A2**
(43) Date of publication of application: **20.08.2003**
(21) Application number: 03250889.7
(22) Date of filing: 13.02.2003
(51) Int. Cl.: H04B 1/10

(54) **Receiver and receiving method**

(30) Priority: 14.02.2002 JP 2002036930
(71) Applicant: Pioneer Corporation, Meguro-ku, Tokyo (JP)
(72) Inventor: Nakamura, Shigeki, Yamada, Kawagoe-shi, Saitama (JP)
(74) Representative: Haley, Stephen

(57) **Abstract**

A receiver 1 comprises a tracking filter 9 connected to the signal receiving side of the field effect transistor (FET) 10 of a tracking filter circuit 2 and a frequency converter 3 connected to the tracking filter circuit 2. A control signal is applied from an AGC circuit 15 to the gate of the FET 10 to detect the receiving level of the signal being received. A predetermined tuning voltage is applied from a D/A converter 7 to the tracking filter 9 according to the control signal from a microcomputer 8. When the signal receiving level is high, a filtering characteristic for power matching is selected for the tracking filter 9. On the other hand, when the signal receiving level falls to a certain extent, a filtering characteristic for NF matching is selected for the tracking filter 9 for the tracking purpose. With this arrangement, the signal receivable range is broadened and the signal receiving sensitivity is improved for the receiver 1.

## Description

### BACKGROUND OF THE INVENTION

This invention relates to a tracking method for tracking a signal being received of a predetermined frequency band, attenuating any other signals outside the frequency band, and also to a device adapted to be used with such a tracking method. The present invention also relates to a receiver.

Conventional receivers for receiving signals of FM (frequency modulation) broadcasting or TV (television) broadcasting comprise a tuner, which is provided with a tracking filter circuit whose filtering characteristic can be changed as a function of the frequency of the electronic wave to be detected. The tracking filter circuit is an electronic device that attenuates any undesired signals and allows only a given signal to pass. It operates to correct the distortion characteristic of the amplifier and that of the mixer of the tuner. The tuner changes the tracking filter characteristic of the tracking filter circuit as a function of the frequency of the signal being received.

The tuners of receivers generally comprise a transistor having a small noise figure (NF) for the first stage amplifier so as to be able to detect a weak electric field. The first stage amplifier is referred to as LNA (low noise amplifier). The noise figure of the LNA varies depending on the upstream and downstream matching circuits connected to it. More specifically, the matching circuit realized for NF matching by selecting an impedance that matches the gamma-optimum specific to the transistor, which may be an FET (field-effect transistor), of the LNA from the viewpoint of the base or the gate and the matching circuit realized for power matching and having a filtering characteristic adapted to maximize the amplification degree and hence minimize the passing loss generally produce different noise figures.

On the other hand, the tracking filter circuit of the tuner is designed to operate both as a matching circuit adapted to produce such a filtering characteristic and a matching circuit adapted to be optimal for the LNA. Therefore, if the tracking filter circuit and the LNA are combined for power matching so as to attenuate unnecessary noises outside the frequency band of the signal being received and at the same time minimize the passing loss of the frequency band, the value of the noise figure will be greater than the corresponding value that is obtained when they are combined for NF matching as described above. Then, since the noise figure obtained when the LNA and the tracking filter circuit are combined for power matching is greater than the one obtained when they are combined for NF matching, the signal reception can be disturbed particularly when the signal level is low.

In view of the above identified circumstances, it is therefore the object of the present invention to provide a receiver and a receiving method that can effectively extract a predetermined frequency band.

According to the invention, the above object is achieved by providing a receiver comprising a tracking filter circuit for selectively extracting a predetermined frequency band, the tracking filter circuit having a filtering characteristic adapted to lay stress on reduction of the passing loss of the predetermined frequency band and a filtering characteristic adapted to lay stress on the noise figure in order to reduce the noise level of the signal being received.

Thus, according to the invention, the passing loss of the predetermined frequency band is reduced due to the filtering characteristic that lays stress on reduction of the passing loss of the predetermined frequency band, while the noise level of the signal being received is reduced to facilitate the extraction of the predetermined frequency band due to the filtering characteristic that lays stress on the noise figure. As a result, the sensitivity of the receiver is improved and the tracking operation is conducted highly sensitively if the level of the signal being received is low.
FIG 1 is a schematic block diagram of an embodiment of receiver according to the invention, illustrating a schematic configuration thereof;
FIG 2 is a schematic circuit diagram of part of the tracking filter circuit of the embodiment of FIG. 1;

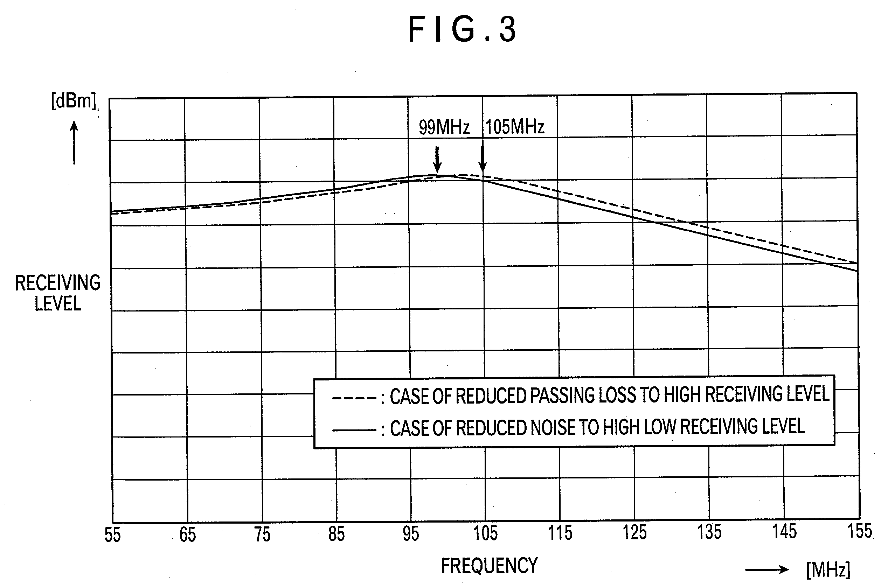

FIG 3 is a graph illustrating the difference between power matching and NF matching of the embodiment of FIG 1 that is obtained as a result of an experiment;
FIG 4 is a graph illustrating the result of a tracking operation of the embodiment of FIG 1 obtained by laying stress on gain when the level of the signal being received is high;
FIG 5 is a graph illustrating the result of a tracking operation of the embodiment of FIG 1 obtained by laying stress on sensitivity when the level of the signal being received is low;
FIG 6 is a graph illustrating the relationship between the level of the signal being received and the elapsed time in order to show the threshold values of the filtering characteristic of another embodiment that is changed corresponding to the level of the signal being received;
FIG. 7 is a graph illustrating the relationship between the BER and the level of the signal being received in order to show the threshold values of the filtering characteristic of the embodiment of FIG. 6 that is changed corresponding to the level of the signal being received;
FIG 8 is a graph illustrating the relationship between the BER and the level of the signal being received in order to show one of the threshold values of the filtering characteristic of the embodiment of FIG. 6 that is changed corresponding to the level of the signal being received; and
FIG. 9 is a graph illustrating the relationship between the BER and the level of the signal being received in order to show the other threshold value of the filtering characteristic of the embodiment of FIG. 6 that is changed corresponding to the level of the signal being received.

Now, an embodiment of the present invention will be described by referring to the accompanying drawings.

### [Configuration of Receiver]

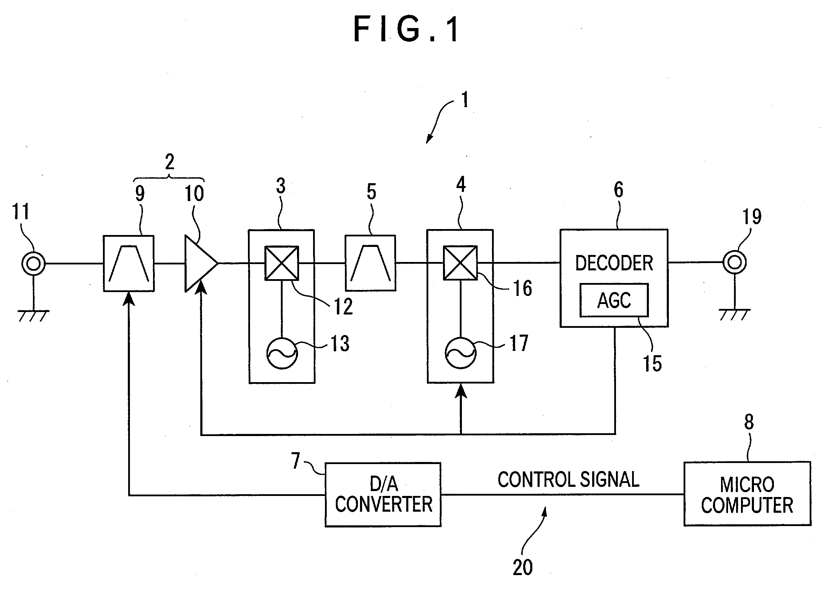

FIG 1 is a schematic block diagram of the embodiment of receiver according to the invention, illustrating a schematic configuration thereof.

Referring to FIG 1, the receiver 1 is typically adapted to receive digital broadcasting transmissions. The receiver 1 comprises a tracking filter circuit 2 operating as the tracking device of a high frequency amplifier (not shown), a pair of frequency converters 3, 4, a filter 5, a composite circuit 6, a D/A converter 7 and a microcomputer 8.

The tracking filter circuit 2 is designed to secure a predetermined channel bandwidth and show selectivity that is adapted to attenuate signals found outside the desired channel to a large extent. The tracking filter circuit 2 has a tracking filter 9 operating as a sort of band pass filter as part of an antenna tuning circuit and a high frequency amplifying transistor operating as part of an LNA (low noise amplifier), which is a high frequency amplifier. The transistor is typically a field effect transistor (FET) 10.

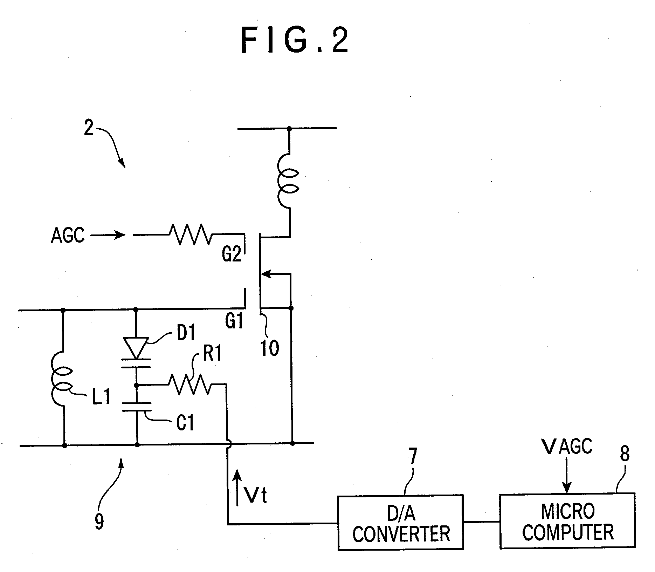

The tracking filter 9 tunes in to the frequency band of the desired channel. More specifically, it comprises a series circuit formed by connecting a diode D1 and a capacitor C1 and connected in parallel with a reactor L1 as shown in the circuit diagram of FIG 2. Thus, the filtering characteristic of the tracking filter 9 is such that the tracking filter 9 operates as band pass filter and tunes in to the frequency band of the desired channel by means of resonance of the capacitor C and the reactor L1. The D/A converter 7 is connected to the contact point of the diode D1 and the capacitor C1 of the tracking filter 9 by way of a resistor R1. Therefore, the capacitance of the diode D1 is changed by the tuning voltage Vt applied to it from the D/A converter 7 for the purpose of tuning (tracking). As shown in FIG 1, the tracking filter 9 is connected to an input terminal 11 which is by turn connected to an antenna (not shown).

The FET 10 has input impedance that is very high if compared with a transistor of any other type so that its operating characteristic shows an excellent linearity. Therefore, it is relatively free from interferences and modulation disturbances. Preferably, a dual gate type metal oxide semiconductor field effect transistor (MOSFET) is used for the FET 10. As shown in the circuit diagram of FIG 2, one of the gates, or gate G1, of the FET 10 is connected to the tracking filter 9.

The signal coming from the antenna is fed to one of the gates, or gate G1, of the FET 10 while the control signal coming form an AGC (automatic gain control) circuit 15 by way of the resistor R1 is applied to the other gate G2 of the FET 10. Then, the FET 10 detects the intensity of the received electronic wave (signal receiving level). The source of the FET 10 is grounded and the high frequency output of the FET 10 is taken out from its drain. One of the pair of frequency converters, or the first frequency converter 3, is connected to the drain of the FET 10.

The first frequency converter 3 is adapted to convert the high frequency signal that is amplified by the FET 10 into an intermediate frequency signal.

The first frequency converter 3 comprises a first mixing circuit 12 and a first local oscillation circuit 13. The first mixing circuit 12 efficiently converts the high frequency signal into an intermediate frequency signal so as to reduce the noise of the signal. The first local oscillation circuit 13 is a highly stable Clapp type oscillation circuit formed on the basis of a simple Colpitts oscillator. It controls the first mixing circuit 12 so as to maintain the intermediate frequency unchanged.

The filter 5 is connected to the first frequency converter 3. Then, the other frequency converter, or the second frequency converter 4, is connected to the filter 5 so as to amplify the intermediate frequency signal produced from the first frequency converter 3.

The composite circuit 6 is connected to the second frequency converter 4.

The composite circuit 6 comprises a detection circuit and an automatic fine tuning (AFT) circuit (not shown) along with the AGC circuit 15 that operates as a judging portion.

The detection circuit detects the intermediate frequency of the carrier wave output from the second frequency converter 4. The AFT circuit regulates the intermediate frequency of the carrier wave so as to make it agree with a given frequency. More specifically, since the oscillation frequency of the second local oscillation circuit 17 that controls the second mixing circuit 16 of the second frequency converter 4 is subject to change with time due to ambient temperature and other factors, the AFT circuit operates to maintain the right frequency. The AGC circuit 15 automatically controls the gain of the receiver 1 according to the intensity of the received electronic wave in order to provide a constant detection output level. The AGC circuit 15 judges the intensity of the input electronic wave on the basis of the detected signal and generates a corresponding control signal.

The composite circuit 6 is connected to an output terminal 19, which outputs a signal whose frequency is so regulated as to agree with a predetermined frequency.

The D/A converter 7 is connected to the microcomputer 8. The D/A converter 7 and the microcomputer 8 operate as a controller 20. For instance, when the microcomputer 8 recognizes that a given channel is selected by means of a switch, it outputs a predetermined control signal to the D/A converter 7 in order to receive the signal of the selected channel. More specifically, the microcomputer 8 supplies a tuning voltage Vt that operates as control signal to the tracking filter 9 by way of the D/A converter 7 so that the filtering characteristic of the tracking filter 9 may allows the frequency band of the selected channel to pass.

The microcomputer 8 is adapted to output either of two control signals to the frequency band of the selected channel. They include a control signal for realizing a filtering characteristic that lays stress on the frequency passing loss of the selected channel (a filtering characteristic for power matching) and a control signal for realizing a filtering characteristic that lays stress on the noise figure (NF) of the frequency band of the selected channel (a filtering characteristic for NF matching). In other words, the microcomputer 8 can regulate the tracking filter 9 so as to make it show either of the two filtering characteristics for the selected channel.

### [Operation of the Receiver]

Now, the operation of the above described receiver 1 will be described by referring to the related drawings.

The tracking filter circuit 2 comprises an FET 10, which has a high input impedance and whose operating characteristic shows an excellent linearity. Thus, it is relatively free from interferences and modulation disturbances and the tracking filter circuit 2 can detects a weak electric field. Therefore, the noise figure of the LNA (low noise amplifier) that comprises the FET 10 varies between the matching circuit realized for power matching in order to maximize the amplification degree and the matching circuit realized for NF matching in order to minimize the noise figure. In other words, as described earlier, the matching circuit realized for NF matching by selecting an impedance that matches the gamma-optimum specific to the transistor, which may be an FET (field-effect transistor), of the LNA from the viewpoint of the base or the gate and the matching circuit realized for power matching and having a filtering characteristic adapted to maximize the amplification degree and hence minimize the passing loss generally produce different noise figures.

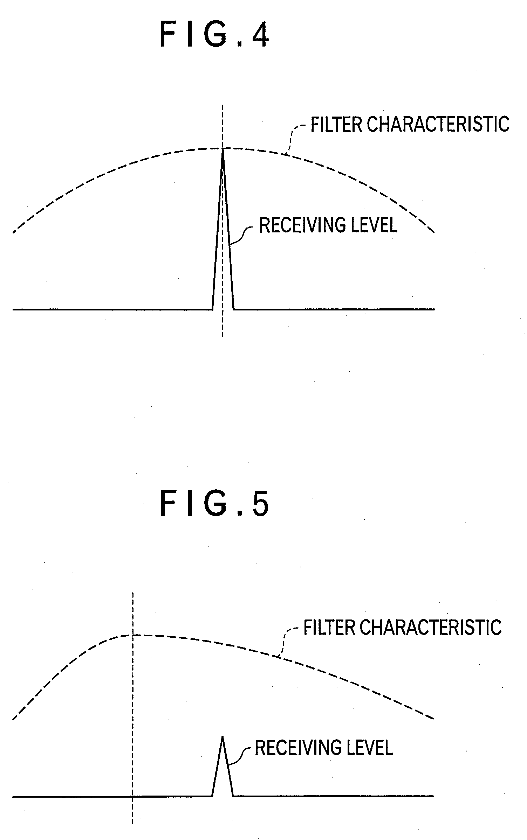

When the receiver 1 receives an electronic wave, firstly the AGC circuit 15 of the composite circuit 6 detects the intensity of the electronic wave received by the antenna (not shown) (signal receiving level). If the AGC circuit 15 recognizes that the signal receiving level is higher than a predetermined value, it lays stress on minimizing the passing loss and changes the filtering characteristic of the tracking filter 9 for the purpose of minimizing the passing loss of the filter as shown in FIG 4.

In other words, the tracking filter 9 is made to tune in to the frequency band of the selected channel so as to adapt the filtering characteristic to power matching in order to maximize the level of the received signal. Differently stated, the microcomputer 8 outputs a predetermined control signal to the D/A converter 7. In response to the control signal, the D/A converter 7 applies a predetermined tuning voltage Vt to the tracking filter 9 in order to change the capacitance of the diode D1 for the purpose of tuning. In this way, unnecessary electronic waves are removed as much as possible in order to receive only the electronic wave of the selected channel in a good condition if the received electronic wave shows a sufficiently high intensity.

If, on the other hand, the AGC circuit 15 of the composite circuit 6 recognizes that the signal receiving level is lower than a predetermined value, it lays stress on the noise figure and changes the filtering characteristic of the tracking filter 9 in a manner as shown in FIG 5.

More specifically, priority is given to the signal receiving sensitivity and the tracking filter 9 is made to tune in to the frequency band of the selected channel in such a way that the frequency of the filtering characteristic that minimizes the passing loss of the filter is slightly shifted to the higher frequency side to produce a satisfactory noise figure. As a result, the sensitivity to the electronic wave to be received is improved and the signal of the selected channel can be received reliably if the electronic wave shows a low intensity.

Thus, the above described embodiment can selectively and effectively extract a predetermined frequency band either by using the filtering characteristic that lays stress on the passing loss to minimize the passing loss of the predetermined frequency band or by using the filtering characteristic that lays stress on the noise figure to minimize the noise level of the received signal. As a result, the embodiment can improve the reception sensitivity if the signal receiving level falls so that it shows a satisfactory tracking performance with an enhanced level of sensitivity.

Due to the use of the FET 10 that can detect a weak electric field, the embodiment can adapt itself to a situation where the noise figure differs between power matching and NF matching. For instance, it may be so arranged that the control signal from the AGC circuit 15 is appropriately applied to the gate of the FET 10 in order to recognize the signal receiving level and the tuning voltage Vt is appropriately applied to the tracking filter 9 from the D/A converter 7 in such a way that the voltage may be high or low depending on the intensity of the recognized signal receiving level in order to select either the filtering characteristic of the tracking filter 9 good for power matching or the filtering characteristic good for NF matching. Differently stated, the filtering characteristic good for NF matching is selected when the signal receiving condition is not good. As a result, it is possible to broaden the range of receiving level of the signal that can be received in order to make the receiver 1 highly sensitive for signal reception.

Additionally, it is so arranged that either power matching or NF matching is selected depending on if the signal receiving level is higher or lower than a predetermined value. As a result, the embodiment can show an excellent tracking performance with an enhanced level of sensitivity, although it has a relatively simple configuration.

### [Other Embodiments]

The present invention is by no means limited to the above described embodiment, which may be modified or altered without departing from the scope of the present invention.

While the receiver 1 is typically adapted to receive digital broadcasting transmissions in the above description, the present invention is applicable to any receivers that can selectively extract a predetermined broadcast wave by means of a tracking filter. Such receivers include FM receiving sets and television broadcasting receiving sets.

While the tracking filter 9 is arranged at the first stage or at a position closer to the input terminal 11 than to the FET 10 in the above description, it may alternatively be arranged at an inter-stage or at a position closer to the output terminal 19 than to the FET 10 and at the same time closer to the input terminal 11 than to the first frequency converter 3. Still alternatively, two tracking filters may be arranged at the respective positions.

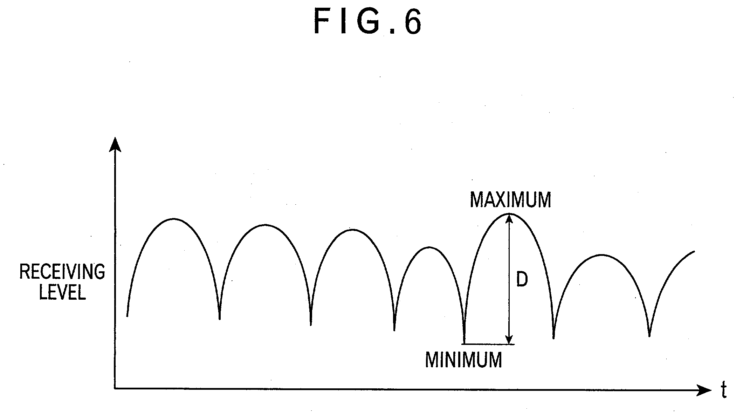

As for the arrangement for detecting the signal receiving level of the AGC circuit 15, the filtering characteristic adapted to power matching and the filtering characteristic adapted to NF matching are appropriately selected depending on if the signal receiving level is higher or lower than a predetermined value in the above description, the filtering characteristic of the tracking filter may alternatively be so designed that it is changed as a function of the fading environment on the basis ofthe judgment of the AGC circuit as illustrated in FIGS. 6 through 9.

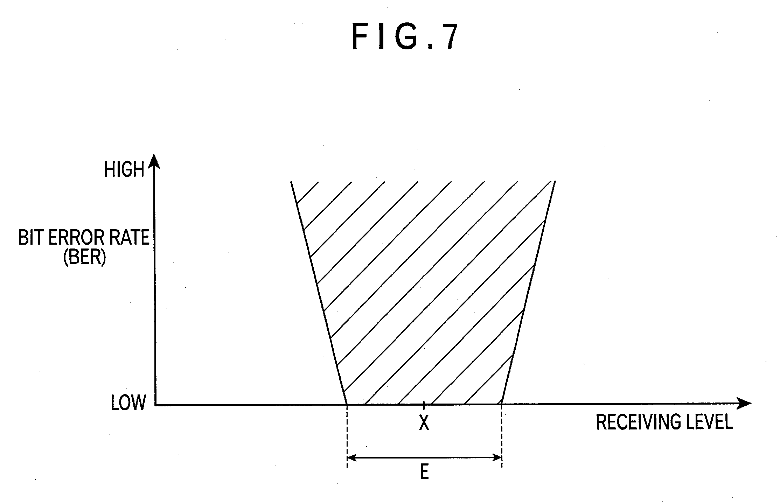

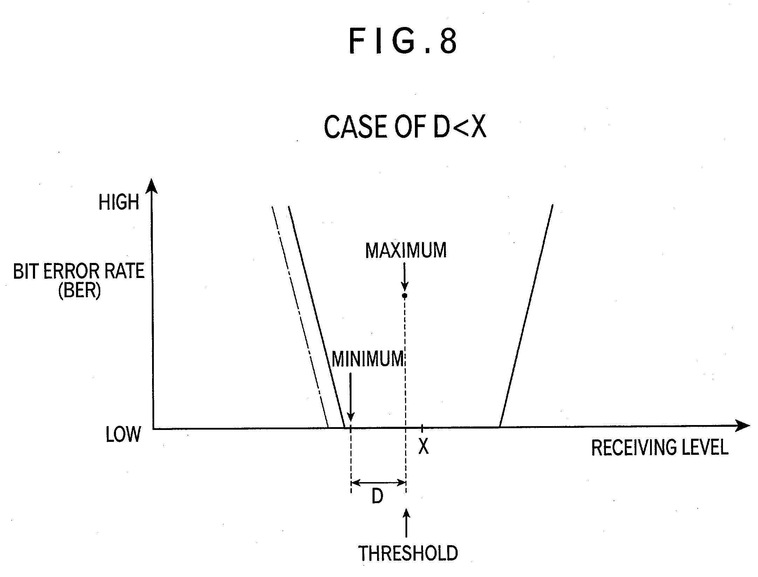

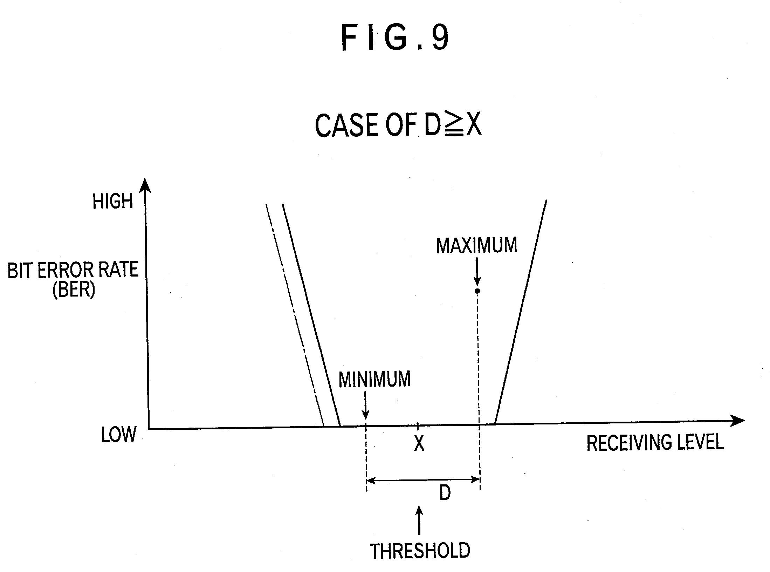

More specifically, two threshold values are defined and selectively used depending on the fading environment. More specifically, the following two threshold values are defined and selectively used depending on the range of fluctuations of the level of the received signal due to fading;
D<X and
D => X (D=X or D>X),
where D : the largest range of fluctuations of the level of the received signal (see FIG 6),
E : the signal receivable range of the receiver 1 (see FIG 7) and
X : the position of the center of the signal receivable range (see FIGS. 8 and 9).

Then, as shown in FIGS. 8 and 9, either one of the above defined two threshold values is selectively used depending on the magnitude of the range of fluctuations of the level of the received signal in order to prevent the minimum value of the range of fluctuations of the received signal from getting to the lowest limit of the signal receivable range E. In other words, priority is given to the signal receiving sensitivity of the receiver from the viewpoint of the filtering characteristic. Then, the sensitivity of the receiver is improved and the signal receivable range is broadened as indicated by the dotted broken line in FIGS. 8 and 9 when the signal receiving level is low. Additionally, the signal can be received optimally depending on the signal receiving level because the maximum value and X are selected respectively when D < X and when D => X to correspond to the magnitude of the range of fluctuations of the signal being received.

Thus, priority is given to the sensitivity for the filtering characteristic when D < X as shown in FIG 8, whereas the filtering characteristic is adapted to power matching when D => X as shown in FIG 9 so that the signal receiving sensitivity is improved by broadening the signal receivable range only when the signal being received goes out of the signal receivable range.

The specific configuration of a receiver according to the invention and the procedure for recognizing an abnormal condition can be modified appropriately without departing from the scope of the present invention.

### [Specific Experiment]

Now, some of the results of an experiment on the signal receiving sensitivity of a receiver according to the above described embodiment will be described below.

In this experiment, a receiver having a configuration as shown in FIG 2 was used. Thus, in the receiver, the control signal from the AGC circuit 15 was applied to the gate G2 of the FET 10 in order to make the FET 10 recognize the signal receiving level and the tuning voltage Vt that was appropriately changeable was applied from the D/A converter 7. For the purpose of comparison, a receiver having a known configuration was used. In the known receiver, the AGC voltage was applied to the gate G2 of the FET 10 for power matching and a uniform tuning voltage Vt was applied from the D/A converter 7 corresponding to the signal receiving level.

In the experiment, a value not greater than -75 dBm and a value not smaller than -20 dBm were selected respectively for the minimum input level and for the maximum input level as target values defined in 5.2.5 of the ARIB (Association of radio Industries and Businesses) STD-B21 3.0 Edition (modulation parameter: Mode 3, the guard ratio: 1/8, no time interleave, modulation 64 QAM, inner code: 7/8). Then, the receivers were made to receive an electronic wave of 105 MHz. The receiver used for the purpose of comparison showed a minimum input level of-75 dBm and a maximum input level of -20 dBm.

On the other hand, in the receiver according to the embodiment, the filter characteristic of the tracking filter 9 was adapted to NF matching and shifted to the frequency that optimizes the noise reducing performance when the signal receiving level came close to the minimum input level from a higher level. When receiving an electronic wave of 105 MHz with a high signal receiving level, the receiver was made to operate for tracking 105 MHz by selecting the filtering characteristic adapted to show a peak of pass band at 105 MHz. When receiving an electronic wave with a low signal receiving level, the filtering characteristic adapted to show a peak of pass band at about 99 MHz, where the noise is reduced remarkably, was selected to operate the receiver for tracking.

With this arrangement, when the signal receiving level falls low, the passing loss of the filter of the receiver according to the invention is reduced by about 1 dB if compared with a conventional receiver where the pass band is fixed to 105 MHz, the noise reduction effect is improved by about 2 dB. As the noise reduction effect is improved by 2 dB, the signal receiving sensitivity is also improved by 2 dB so that the minimum input level can be extended to -77 dBm.

It will be appreciated that, the shift of the peak of the pass band of the tracking filter 9 to about 99 MHz for receiving an electronic wave of 105 MHz corresponds to a shift of a channel that represents a difference of about 6 MHz of ISDB (Integrated Service of Digital Broadcasting)-T.

## Claims

1. A receiver comprising a tracking filter circuit for selectively extracting a predetermined frequency band,
the tracking filter circuit having a filtering characteristic adapted to lay stress on reduction of the passing loss of the predetermined frequency band and a filtering characteristic adapted to lay stress on the noise figure in order to reduce the noise level of the signal being received.

2. The receiver according to claim 1, wherein
the receiver further comprises a judging portion for judging the quality of the signal being received and the tracking filter circuit extracts the predetermined frequency band by selecting the filtering characteristic adapted to lay stress on the noise figure to reduce the noise level when the judging portion judges the quality of the signal being received to be not good.

3. The receiver according to claim 1 or 2, wherein
the tracking filter circuit selects either the filtering characteristic adapted to lay stress on reduction of the passing loss of the predetermined frequency band or the filtering characteristic adapted to lay stress on the noise figure depending on the power level of the signal being received.

4. A receiving method for selectively extracting a predetermined frequency band by utilizing both a filtering characteristic adapted to lay stress on reduction of the passing loss of the predetermined frequency band and a filtering characteristic adapted to lay stress on the noise figure in order to reduce the noise level of the signal being received.

5. The method according to claim 4, wherein
the quality of the signal being received is judged and the predetermined frequency band is extracted by selecting the filtering characteristic adapted to lay stress on the noise figure when the quality of the signal being received is judged to be not good.

6. The method according to claim 4 or 5 wherein,
either the filtering characteristic adapted to lay stress on reduction of the passing loss of the predetermined frequency band or the filtering characteristic adapted to lay stress on the noise figure is selected to extract the predetermined frequency band depending on the power level of the signal being received.
